# EUROPEAN PATENT APPLICATION

(11) **EP 4 567 074 A1**
(43) Date of publication of application: **11.06.2025**
(21) Application number: 23850097.9
(22) Date of filing: 01.08.2023
(51) Int. Cl.: C08L 101/00, C08L 33/04, C08L 61/20, C23C 18/16

(54) **RESINOUS LIQUID AND METHOD FOR FORMING SHAPED OBJECT**

(30) Priority: 05.08.2022 JP 2022125909
(71) Applicant: EEJA Ltd., Tokyo 103-0025 (JP)
(72) Inventor: ITO Masahiro, Hiratsuka-shi, Kanagawa 254-0076 (JP)
(74) Representative: HGF
(86) International application number: PCT/JP2023/028180
(87) International publication number: WO 2024/029543

(57) **Abstract**

Provided is a resin liquid and a method of forming a shaped object suitable for producing a shaped object including a three-dimensional metal structure. The resin liquid contains a photo-radical curable resin; a thermosetting resin; and an acid catalyst. The thermosetting resin contains a melamine crosslinking agent or a benzoguanamine crosslinking agent. The thermosetting resin content of the resin liquid is 3 wt% to 60 wt%.

## Description

### TECHNICAL FIELD

The present disclosure relates to a resin liquid and a method of forming a shaped object.

### BACKGROUND

JP 2019-123909 A (Patent Literature (PTL) 1) describes a structure for electroless plating and an electric circuit structure using a primer layer, as well as an electroless plating pretreatment method and an electroless plating method. The structure for electroless plating comprises an insulating base material, a primer layer, and a catalyst metal layer. In the structure for electroless plating, the catalyst metal layer consists of monodisperse metal nanoparticles having a particle size of 2 nm to 100 nm, the primer layer has an amino group, the catalyst metal layer is formed on the primer layer by an aqueous solution in which the monodisperse metal nanoparticle groups are uniformly dispersed, and the catalyst metal layer and the primer layer are bonded via the amino group on the primer layer.

JP 2012-006234 A (PTL 2) describes a three-dimensional polymer-metal composite microstructure and a method of producing same. In the production method, a polymer structure is formed by stereolithography using a photo-curable resin having a reactive group X, which is then immersed in a liquid of metal-containing nanoparticles having a reactive group X' that bonds with the reactive group X to form a polymer-metal composite structure having a three-dimensional structure by forming a metal-containing layer such as gold on the polymer structure. An example of the reactive group X is an amino group. The amino group is protected to be stable during stereolithography, but is made to produce an active primary amine upon contact with water. PTL 2 further describes a method including a process of forming a fine first member having an arbitrary three-dimensional structure by stereolithography, and a process of forming a fine second member having an arbitrary three-dimensional structure and connecting to the first member by stereolithography, in which a fine polymer structure is formed as an integrally formed product including the first member and the second member, and a metal-containing layer is formed on only either the first member or the second member. In this case, the first member and the second member are indicated to have different reactive groups.

JP 2017-218604 A (PTL 3) describes a method of forming a plating film on a stereolithographic article. The method of forming a plating film on a stereolithographic article includes a first process of preparing a stereolithographic article having a three-dimensional structure made by curing and laminating layers of epoxy resin by stereolithography, a second process of surface-finishing a surface of the stereolithographic article to an arithmetic mean roughness Ra of 0.141 µm or more, preferably 0.458 µm or less, by polishing, grinding, blasting, or a combined mechanical treatment using an #800 to #2000 abradant or a combination thereof, and a third process of forming electroless nickel plating to form a plating film on the surface of the stereolithographic article without performing an etching process. In the third process, a pretreatment process is performed, including a sensitizing process of forming a tin compound coating film on the surface of the stereolithographic article using a tin sol solution and an activating process causing a plating catalyst consisting of palladium to be adsorbed on the surface of the stereolithographic article using a solution containing palladium ions. After the pretreatment process, electroless nickel plating is applied to the surface of the stereolithographic article.

JA 2021-006405 A (PTL 4) describes a method of producing a three-dimensional object from materials having various curing mechanisms. The method of producing a three-dimensional object includes: a process of preparing a carrier and an optically transparent member having a build surface; a process of filling a build region with a polymerizable liquid, the polymerizable liquid including a mixture of a first component of a photopolymerizable liquid and a second component having a different solidifying property than the first component; and a process of irradiating the build region with light through the optically transparent member to form a solid polymer scaffold from the first component and moving the carrier away from the build surface to form a three-dimensional intermediate having the same shape as the three-dimensional object or a shape to be imparted to the three-dimensional object, wherein the three-dimensional intermediate contains the second component carried within the scaffold in an unsolidified form and/or uncured form; and a process of forming the three-dimensional object by solidifying and/or curing the second component within the three-dimensional intermediate at the same time as or subsequent to the irradiation process. The second component includes, for example, polyurethane, polyurea, or a copolymer precursor thereof, silicone resin, or natural rubber, and the solidifying and/or curing process is performed by heating or microwave irradiation.

### CITATION LIST

### Patent Literature

PTL 1: JP 2019-123909 A
PTL 2: JP 2012-006234 A
PTL 3: JP 2017-218604 A
PTL 4: JP 2021-006405 A

### SUMMARY

### (Technical Problem)

As described in PTL 1, there is a need to construct metal structures such as electric circuits using a plating method and shaped objects including such structures. In recent years, there has been a particular need to construct shaped objects that include three-dimensional metal structures. The method of producing a metal-containing structure or shaped object as described in PTL 2 requires the formation of a three-dimensional structure using two or more types of photo-curable resins having different reaction groups separately and then forming a metal-containing layer, and the process is complicated, and is therefore not sufficiently suitable for constructing a shaped object including a three-dimensional metal structure. Similarly, the method of forming a plating film on a stereolithographic article, as described in PTL 3, cannot form an appropriate plating film on a location that cannot be polished, and is therefore not sufficiently suitable for constructing a shaped object including a three-dimensional metal structure. Thus, there is room for improvement in resin liquids and methods of forming shaped objects suitable for producing shaped objects including three-dimensional metal structures. Therefore, it is desirable to provide a resin liquid and a method of forming a shaped object suitable for producing a shaped object including a three-dimensional metal structure.

In view of the circumstances described above, it would be helpful to provide a resin liquid and a method of forming a shaped object suitable for producing a shaped object including a three-dimensional metal structure.

### (Solution to Problem)

The resin liquid according to the present disclosure comprises:
a photo-radical curable resin; a thermosetting resin; and an acid catalyst, wherein
the thermosetting resin comprises a melamine crosslinking agent or a benzoguanamine crosslinking agent, and
the thermosetting resin content is 3 wt% to 60 wt%.

The method of forming a shaped object according to the present disclosure comprises:
a shaping process of shaping using a resin liquid, wherein the resin liquid comprises a photo-radical curable resin, a thermosetting resin, and an acid catalyst, the thermosetting resin comprises a melamine crosslinking agent or a benzoguanamine crosslinking agent, and the thermosetting resin content is 3 wt% to 60 wt%, to obtain a first-stage shaped object;
a finishing photo-curing process of irradiating the first-stage shaped object with light having a wavelength of 300 nm or more to photo-cure the first-stage shaped object to obtain a second-stage shaped object; and
a thermosetting process of heating the second-stage shaped object to a temperature from 60 °C to 280 °C to thermoset the second-stage shaped object to obtain a third-stage shaped object.

### (Advantageous Effect)

A resin liquid and a method of forming a shaped object suitable for producing a shaped object including a three-dimensional metal structure can be provided.

### BRIEF DESCRIPTION OF THE DRAWINGS

In the accompanying drawings:
FIG. 1 is an SEM image of a surface of a third-stage shaped object of Example 1 with a gold nanoparticle catalyst loaded;
FIG. 2 is a photograph of a third-stage shaped object and metal structure of Example 1;
FIG. 3 is a photograph of a third-stage shaped object and metal structure of Example 3;
FIG. 4 is a photograph of a third-stage shaped object and metal structure of Example 4;
FIG. 5 is a photograph of a shaped object of Example 8 (1 % thermosetting resin content);
FIG. 6 is a photograph of a shaped object of Example 8 (10 % thermosetting resin content); and
FIG. 7 is a photograph of a shaped object of Example 8 (70 % thermosetting resin content).

### DETAILED DESCRIPTION

The following describes the resin liquid and method of forming a shaped object according to embodiments of the present disclosure.

The resin liquid according to the present embodiment contains a photo-radical curable resin, a thermosetting resin, and an acid catalyst. The resin liquid contains a melamine crosslinking agent or benzoguanamine crosslinking agent as the thermosetting resin. In the resin liquid, the thermosetting resin content is 3 wt% to 60 wt%.

The method of forming a shaped object according to the present embodiment includes: a shaping process of shaping using the resin liquid according to the present embodiment to obtain a first-stage shaped object; a finishing photo-curing process of irradiating the first-stage shaped object with light having a wavelength of 300 nm or more to photo-cure the first-stage shaped object to obtain a second-stage shaped object; and a thermosetting process of heating the second-stage shaped object to a temperature from 60 °C to 280 °C to thermoset the second-stage shaped object to obtain a third-stage shaped object.

According to the resin liquid and the method of forming a shaped object, a resin liquid and a method of forming a shaped object suitable for producing a shaped object including a three-dimensional metal structure can be provided. That is, the first-stage shaped object shaped using the resin liquid may not have sufficient solidity to maintain the three-dimensional structure for a long period of time or to be handled without destroying the shape, but the resin liquid contains a photo-radical curable resin, and therefore, via the photo-curing process, the second-stage shaped object has sufficient solidity to maintain the three-dimensional structure. Further, the resin liquid contains a thermosetting resin and an acid catalyst, and therefore allows the second-stage shaped object to be completely cured by the thermosetting process and to become the third-stage shaped object having an amino group on a shaped object surface to load a catalyst for electroless plating. That is, by using the resin liquid according to the present embodiment and subjecting the resin liquid to the method of forming a shaped object, the third-stage shaped object can be obtained that is a suitable substrate for producing a shaped object including a three-dimensional metal structure.

The resin liquid and the method of forming a shaped object are described in detail below.

The resin liquid according to the present embodiment contains a photo-radical curable resin, a thermosetting resin, and an acid catalyst, and may further contain fillers, pigments, and other additives.

Fillers, pigments, and other additives may be used without particular restriction as long as they do not inhibit photo-radical curing and thermosetting to an extent that impairs the purpose of the present embodiment, and they do not deactivate an amino group of the thermosetting resin to an extent that impairs the purpose of the present embodiment.

The photo-radical curable resin is a material that, through a curing reaction, constructs a shaped object that serves as a support to hold a three-dimensional metal structure. According to the present embodiment, the concept of photo-radical curable resin includes prepolymers or monomers that have relatively small molecular weight as resins, specifically, those that can become photo-radical curable resins. The weight-average molecular weight is preferably from 150 to 20,000.

The photo-radical curable resin contains at least one selected from the group consisting of urethane acrylate, epoxy acrylate, acrylic acrylate, polyester acrylate, and acrylate monomer.

The photo-radical curable resin preferably contains a photoinitiator. As the photoinitiator, examples include an alkylphenone photoinitiator, an acylphosphine oxide photoinitiator, an oxime ester photoinitiator, a thioxanthone intramolecular hydrogen abstraction photoinitiator, and the like.

As the thermosetting resin, examples include alkylated amino resins, specifically a melamine crosslinking agent or a benzoguanamine crosslinking agent.

As the melamine crosslinking agent, examples include methylol melamine or a methylol melamine derivative. As the melamine crosslinking agent, examples include melamine, a methylol melamine derivative obtained by condensing melamine and formaldehyde, a partially or completely etherified compound obtained by reacting methylol melamine with a lower alcohol, a mixture of these, and the like. As the lower alcohol, examples include an aliphatic alcohol having 1 to 4 carbon atoms. Further, the melamine crosslinking agent may be a monomer, a condensation product of a dimer or higher polymer, or a mixture of the above. When the melamine crosslinking agent is a monomer, hexamethoxymethylmelamine is preferably used. Specific examples of the condensation product of a polymer include an imino group methylated melamine resin, a methylol group melamine resin, a methylol group methylated melamine resin, a fully alkyl methylated melamine resin, and the like.

As the benzoguanamine crosslinking agent, examples include methylol benzoguanamine or a methylol benzoguanamine derivative. As the benzoguanamine crosslinking agent, examples include benzoguanamine, a methylolated benzoguanamine derivative obtained by condensing benzoguanamine and formaldehyde, a partially or completely etherified compound obtained by reacting methylol benzoguanamine with a lower alcohol, a mixture these, and the like. As the lower alcohol, examples include an aliphatic alcohol having 1 to 4 carbon atoms. Further, the benzoguanamine crosslinking agent may be a monomer, a condensation product of a dimer or higher polymer, or a mixture of the above. When the benzoguanamine crosslinking agent is a monomer, tetramethoxymethylbenzoguanamine is preferably used. Specific examples of the condensation product of a polymer include butylated benzoguanamine resin, methylol benzoguanamine resin, and the like.

A benzoguanamine crosslinking agent may be used together with a melamine crosslinking agent.

As the acid catalyst, examples include a sulfonic acid-based acid catalyst or a phosphoric acid-based acid catalyst. For example, a dinonylnaphthalene disulfonic acid catalyst, a dinonylnaphthalene sulfonic acid catalyst, a p-toluenesulfonic acid, or a blocked acid catalyst of any of these and a blocked acid catalyst of phosphoric acid can be used.

The resin liquid according to the present embodiment contains the photo-radical curable resin as described above. This allows the second-stage shaped object to be cured by a photo-curing process.

The resin liquid according to the present embodiment has a content ratio of the photo-radical curable resin, in terms of mass ratio excluding solvent, from 40 % to 97 %, and preferably from 50 % to 95 %. This allows the second-stage shaped object via the photo-curing process to have a sufficiently suitable solidity to maintain a three-dimensional structure.

The resin liquid according to the present embodiment contains the thermosetting resin containing the melamine crosslinking agent or the benzoguanamine crosslinking agent and the acid catalyst, and therefore allows the second-stage shaped object to be completely cured by the thermosetting process and to become the third-stage shaped object having an amino group on a shaped object surface to load a catalyst for electroless plating.

The resin liquid according to the present embodiment has a content ratio of the thermosetting resin, in terms of mass ratio excluding solvent, from 3 % to 60 %, and preferably from 5 % to 50 %. This allows the third-stage shaped object via the thermosetting process to have an appropriate strength as a three-dimensional metal structure.

The resin liquid according to the present embodiment may contain solvent as required for viscosity adjustment or other purposes.

As described above, the method of forming a shaped object according to the present embodiment includes the shaping process to obtain the first-stage shaped object, the finishing photo-curing process to obtain the second-stage shaped object from the first-stage shaped object, and the thermosetting process to obtain the third-stage shaped object from the second-stage shaped object.

The shaping process is a process of obtaining the first-stage shaped object having a shape corresponding to a shaped object including a three-dimensional metal structure from the resin liquid according to the present embodiment.

The shaping process can be performed by a so-called 3D printer. As examples of 3D printer methods: the stereolithography apparatus (SLA) method may be used to construct a three-dimensional shape by irradiating the resin liquid with points of ultraviolet or other light to gradually harden the resin from a base in layers; the digital light projector (DLP) method may be used to create a three-dimensional shape by irradiating the resin liquid with planes of ultraviolet or other light to gradually harden the resin from a base in layers; and the material jetting (MJ) method (also known as the inkjet method) may be used to create a three-dimensional shape by spraying the resin liquid from a plurality of nozzles while irradiating the resin liquid with ultraviolet or other light to harden the resin in layers.

The first-stage shaped object does not need to be sufficiently solid to maintain the three-dimensional structure for a long period of time or to be handled without destroying the shape, but only needs to be strong enough to be used in the photo-curing process.

The wavelength of light used for photo-curing the resin liquid in the shaping process is ultraviolet light from 300 nm to 450 nm, preferably from 350 nm to 410 nm. Photo-curing the resin liquid using light having a wavelength of 300 nm or more can suppress deactivation of the amino group used to load the catalyst for electroless plating.

The first-stage shaped object is finish-cured by the finishing photo-curing process to become the second-stage shaped object having sufficient solidity to maintain the three-dimensional structure for a long period of time or to be handled without destroying the shape.

In the finishing photo-curing process, the first-stage shaped object is irradiated with ultraviolet light having a wavelength from 300 nm to 450 nm, preferably from 350 nm to 410 nm. This allows curing of the first-stage shaped object while also suppressing deactivation of the amino group for loading the catalyst for electroless plating.

The second-stage shaped object is thermoset by the thermosetting process to be completely cured, and becomes the third-stage shaped object having an amino group on a shaped object surface to load a catalyst for electroless plating. In the thermosetting process, the second-stage shaped object is thermoset by heating to a temperature from 60 °C to 280 °C. When the heating temperature in the thermosetting process is too low, the time required for thermosetting may be too long, and when too high, a component of the third-stage shaped object may be altered or deteriorated. In the case that the time required for thermosetting may be longer, a heating temperature of 60 °C or lower may be adopted. Further, in the case that none of the components of the third-stage shaped object would be altered or deteriorated, a heating temperature of 280 °C or higher may be adopted. In most cases, a heating temperature from 80 °C to 150 °C is suitable.

The third-stage shaped object is then subjected to a catalyst loading process to form a catalyst-loaded region with metal nanoparticles loaded on a surface thereof. The catalyst-loaded region can be easily plated with a plating process that applies a reduction-type electroless plating. The third-stage shaped object is a suitable substrate for the production of a shaped object including a three-dimensional metal structure, as described below.

In the catalyst loading process, metal nanoparticles are adsorbed by and loaded onto an amino group on the surface of the third-stage shaped object. Therefore, prior to the catalyst loading process, by forming a region where the amino group has been deactivated and a region where the amino group is preserved without being deactivated on the surface of the third-stage shaped object, it is possible to realize loading of metal nanoparticles only on the region where the amino group is preserved without being deactivated in the catalyst loading process. That is, electroless plating can be realized in only the region where the amino group is preserved without being deactivated.

One example of a process for realizing a method for forming a region where the amino group is deactivated and a region where the amino group is preserved without being deactivated on the surface of the third-stage shaped object is a patterning process in which a portion of the surface of the third-stage shaped object is irradiated with light having a wavelength of less than 300 nm (deep UV light) to form an irradiated region irradiated with light having a wavelength of less than 300 nm and a non-irradiated region not irradiated with light having a wavelength of less than 300 nm.

In the patterning process, a portion of the surface of the third-stage shaped object can be irradiated with light having a wavelength less than 300 nm (that is, partial irradiation with light having a wavelength less than 300 nm is performed) to form a region where the amino group is deactivated on the surface of the third-stage shaped object. On the surface of the third-stage shaped object, a non-irradiated region is a region where the amino group is preserved without being deactivated.

By forming a region where the amino group is deactivated and a region where the amino group is preserved without being deactivated, as in the patterning process, a plated portion in the plating process, that is, a shape of a three-dimensional metal structure, can be drawn. That is, the patterning process, the catalyst loading process, and the plating process can be used to construct a three-dimensional metal structure using the third-stage shaped object as a substrate.

In the patterning process, a photomask such as a quartz mask or metal mask may be used for partial irradiation with light having a wavelength of less than 300 nm, or partial irradiation by a deep ultraviolet laser may be used.

A pretreatment solution for electroless plating used in the catalyst loading process is preferably a colloidal solution containing metal nanoparticles that are a catalyst for reduction-type electroless plating. The pretreatment solution for electroless plating is preferably a pretreatment solution for electroless plating comprising metal nanoparticles of group IB or group VIIIB of the periodic table, sugar alcohol, and water.

The pretreatment solution for electroless plating preferably has pH = 6.5 to 8.0 and zeta potential = -50 mV to -80 mV. In the pretreatment solution for electroless plating, the metal nanoparticles preferably have an average particle size = 10 nm to 40 nm and a metal concentration = 50 mg/L to 200 mg/L. In the pretreatment solution for electroless plating, the sugar alcohol concentration is preferably from 0.05 g/L to 1.0 g/L.

The metal nanoparticles are nanoparticles of elements in group IB or group VIIIB of the periodic table. Specifically, gold (Au), silver (Ag), copper (Cu), platinum (Pt), palladium (Pd), rhodium (Rh), iridium (Ir), ruthenium (Ru), nickel (Ni), cobalt (Co), and iron (Fe). These metals can be dispersed in the liquid in a stable colloidal state by the sugar alcohol. In particular, the metal nanoparticles are preferably colloidal nanoparticles of gold (Au), platinum (Pt), or palladium (Pd).

The sugar alcohol is preferably one or more of the group consisting of glycerol, tetritols, pentitols, hexitols, heptitols, octitols, inositol, quercitol, and pentaerythritol.

Further, preferred combinations are as follows. When the colloidal nanoparticles are any of platinum (Pt) nanoparticles, palladium (Pd) nanoparticles, or gold (Au) nanoparticles, the sugar alcohol is preferably one or more of glycerin, erythritol, xylitol, mannitol, inositol, or pentaerythritol.

In the catalyst loading process, the third-stage shaped object is brought into contact with the pretreatment solution for electroless plating, such as by immersing the third-stage shaped object in the pretreatment solution for electroless plating. As a result, the metal nanoparticles are adsorbed and loaded in the region where the amino group is preserved without being deactivated, that is, in the non-irradiated region.

In the plating process, the third-stage shaped object with metal nanoparticles adsorbed on the surface is immersed in a reduction-type electroless plating solution. As a result, the metallic nanoparticles become catalysts for the electroless plating reaction, and the electroless plating reaction proceeds to form a metal film in the non-irradiated region. In this way, a shaped object can be constructed that includes a three-dimensional metal structure formed following the surface profile of the third-stage shaped object.

### EXAMPLES

In the following, the resin liquid and the method of forming a shaped object according to the present embodiment are described by means of examples. In the following description, "%" written without further definition means "wt%".

### (Example 1)

A resin liquid for forming a shaped object was prepared having a pre-made photo-radical curable type of photo-curable resin liquid content of 90 % (product name: Clear Resin, produced by Formlabs, containing 15 % to 25 % methacrylate monomer, 55 % to 75 % urethane acrylate, and 0.9 % acylphosphine oxide photoinitiator as main components), a methylol melamine crosslinking agent content of 9 % (product name: CYMEL^{®} 303 LF (CYMEL is a registered trademark in Japan, other countries, or both), produced by Allnex GMBH, containing 99 % or more alkylated melamine as the main component), and a sulfonic acid-based acid catalyst content of 1 % (product name: CYCAT^{®} 4040 (CYCAT is a registered trademark in Japan, other countries, or both), produced by Allnex GMBH, containing 40 % p-toluenesulfonic acid and 54 % isopropanol as main components). In this resin liquid, the photo-radical curable type of photo-curable resin content was 89 % and the thermosetting resin content was 10 %. Further, the acid catalyst content was 1 %.

The resin liquid was loaded into an SLA-type 3D printer (product name: Form 2, produced by Formlabs), and 3D shaping was performed to obtain a first-stage shaped object in the shape of a cubic lattice having six lattice faces. The light used for photo-curing in the 3D shaping was ultraviolet and blue-violet light having a central wavelength of 405 nm, and did not include light having a wavelength of less than 300 nm.

The first-stage shaped object was washed with ethanol, and then irradiated with light having a central wavelength of 405 nm (and no light having a wavelength of less than 300 nm) for secondary curing to obtain a second-stage shaped object.

The second-stage shaped object was heated in an oven under an atmosphere with an internal ambient temperature of 100 °C. The heating time in the oven (hold time in the oven) was 10 minutes. Accordingly, the second-stage shaped object was thermoset to obtain a third-stage shaped object.

Next, the third-stage shaped object was pretreated for reduction-type electroless plating by immersion in a gold nanoparticle catalyst colloid solution for electroless plating (product name: SEADCAT^{®} CAT-Au10 (SEADCAT is a registered trademark in Japan), produced by EEJA) as a pretreatment solution for electroless plating. The temperature of the pretreatment solution for electroless plating during pretreatment was 25 °C. The immersion time of the third-stage shaped object in the pretreatment solution for electroless plating during pretreatment was 15 minutes.

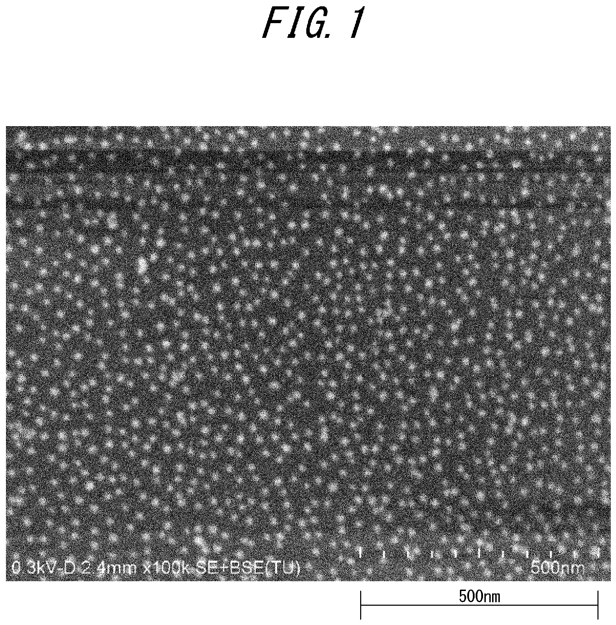

This pretreatment resulted in the uniform adsorption and loading of gold nanoparticle catalyst having a particle size of approximately 20 nm on the surface of the third-stage shaped object (see FIG. 1).

Next, the third-stage shaped object after pretreatment was immersed in a reduction-type electroless gold plating solution (product name: AC FAB Au-ACG3000WX, produced by EEJA), and reduction-type electroless plating treatment was performed. The temperature of the electroless gold plating solution during the plating process was 65 °C. The immersion time of the third-stage shaped object in the electroless gold plating solution during the plating process was 20 minutes.

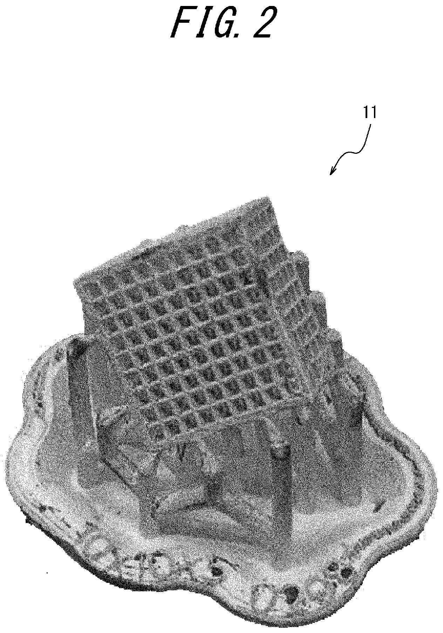

The electroless gold plating produced a gold film 200 nm thick over the entire surface of the third-stage shaped object, that is, a three-dimensional metal structure having a shape following the surface of the third-stage shaped object (see FIG. 2). In FIG. 2, the lattice cube indicated as structure 11 is the metal structure formed on the surface of the third-stage shaped object according to Example 1. FIG. 2 illustrates a photograph of the structure 11 held in place by a base portion (support) formed during 3D shaping.

### (Example 2)

Example 2 differs from Example 1 in that a methylol/n-butyrol benzoguanamine crosslinking agent (product name: BX-4000, produced by Nippon Carbide Industries Co., Inc., containing 99 % or more methylol/n-butyrol benzoguanamine as the main component) was used instead of the methylol melamine crosslinking agent, and was otherwise the same. As with Example 1, electroless gold plating was used to obtain a three-dimensional metal structure having a shape following the surface of the third-stage shaped object.

### (Example 3)

Example 3 differs from Example 1 in that instead of the pre-made photo-radical curable type of photo-curable resin liquid, a resin liquid mix was used having a bifunctional acrylate monomer content of 89 % (product name: IRR 214-K, produced by Daicel-Allnex Ltd., containing 99 % tricyclodecane dimethanol diacrylate as the main component) and an acylphosphine oxide photoinitiator content of 1 % (product name: Omnirad 819, produced by IGM Resins B.V., containing 99 % 2,4,6-trimethylbenzoyl-diphenyl phosphine oxide as the main component) as the photo-radical curable type of photo-curable resin liquid. Further, the acid catalyst (product name: CYCAT^{®} 4040) was replaced with an acid catalyst (product name: NACURE X49-110, from Kusumoto Chemicals Ltd., containing 25 % dinonylnaphthalene disulfonate and 75 % isopropanol and isobutanol mixed solvent as the main components). Otherwise the resin liquid was prepared in the same way as in Example 1. In this resin liquid, the solid content was 90 % photo-radical curable type of photo-curable resin liquid and 10 % thermosetting resin.

The resin liquid was loaded into an SLA-type 3D printer (product name: Form 2, produced by Formlabs), and 3D shaping was performed to obtain a first-stage shaped object in the shape of a disk. The light used for photo-curing in the 3D shaping was ultraviolet and violet light having a central wavelength of 405 nm, and did not include light having a wavelength of less than 300 nm.

Next, the surface of the third-stage shaped object was irradiated with deep ultraviolet light (product name of light source: Deep UV lamp UXM-501MD, produced by Ushio Inc.) having a central wavelength of 254 nm through a quartz photo mask to form irradiated and non-irradiated regions. The irradiation dose was 1000 mJ/cm² (measured at the central wavelength of 254 nm).

The third-stage shaped object after the formation of the irradiated and non-irradiated regions was pretreated with the pretreatment solution for electroless plating in the same way as in Example 1.

Next, the third-stage shaped object after pretreatment was immersed in a reduction-type electroless gold plating solution (product name: AC FAB Au-ACG3000WX, produced by EEJA), and reduction-type electroless plating treatment was performed. The temperature of the electroless gold plating solution during the plating process was 65 °C. The immersion time of the third-stage shaped object in the electroless gold plating solution during the plating process was 10 minutes.

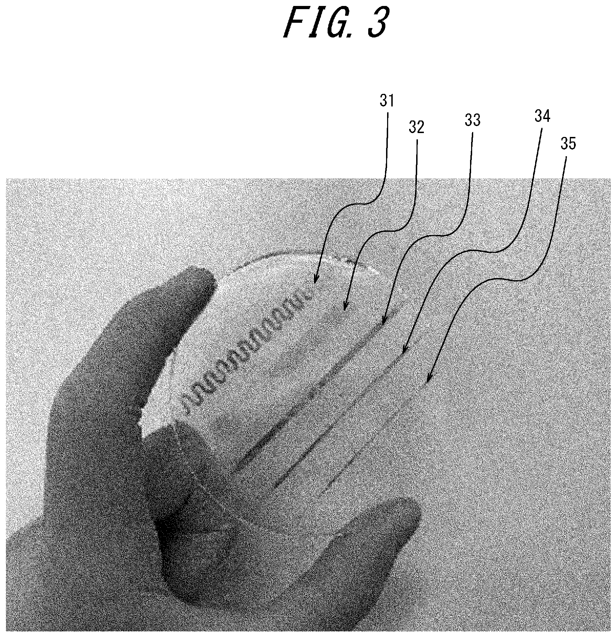

The electroless gold plating produced a gold film 100 nm thick on a portion of the surface of the disk-shaped third-stage shaped object, that is, a wiring pattern structure of metal in shapes following the surface of the third-stage shaped object (see FIG. 3). In FIG. 3, the linear patterns of metal indicated as structures 31, 32, 33, 34, 35 are metal structures according to Example 3, formed on the third-stage shaped object.

### (Example 4)

In Example 4, the same pre-made photo-radical curable type of photo-curable resin liquid as used in Example 1 was used, but unlike Example 1, the first-stage shaped object was rectangular in shape and had a helical (coiled) tunnel space (channel) inside. The first-stage shaped object was shaped by an SLA-type 3D printer as in Example 1.

A second-stage shaped object was obtained from the first-stage shaped object in the same manner as in Example 1, and a third-stage shaped object was obtained from the second-stage shaped object in the same manner as in Example 1.

Next, the surface of the third-stage shaped object was irradiated with deep ultraviolet light (product name of light source: Deep-UV lamp UXM-501MD, produced by Ushio Inc.) having a central wavelength of 254 nm. The irradiation dose was 1000 mJ/cm² (measured at the central wavelength of 254 nm). The third-stage shaped object did not transmit deep-ultraviolet light, and therefore the inner surface of the helical tunnel space in the third-stage shaped object became a non-irradiated region, while the other surfaces of the third-stage shaped object became an irradiated region.

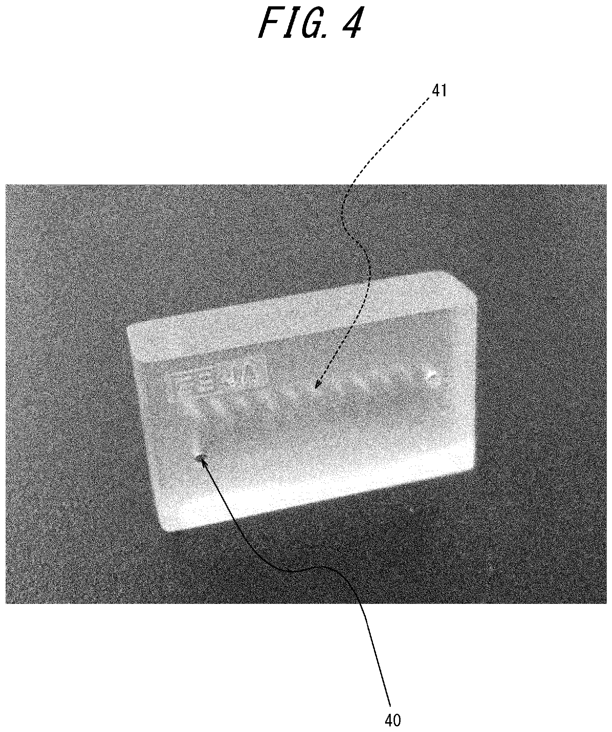

The third-stage shaped object after forming the irradiated region and the non-irradiated region was pretreated with the pretreatment solution for electroless plating in the same way as in Example 1, and further subjected to electroless plating. This resulted in a gold film 200 nm thick only on the inner surface of the helical tunnel space of the third-stage shaped object, that is, a tubular, helical, three-dimensional metal structure (see FIG. 4) having a shape following the inner surface of the helical tunnel space of the third-stage shaped object. In FIG. 4, the tubular, helical structure 41 formed in the helical tunnel space 40 is the metal structure for Example 4, formed inside the third-stage shaped object.

### (Example 5)

Example 5 differs from Example 1 in that instead of the pre-made photo-radical curable type of photo-curable resin liquid, a resin liquid mix was used having a bifunctional acrylate monomer content of 89 % (product name: HDDA, produced by Daicel-Allnex Ltd., having 99 % 1,6-hexanediol diacrylate as the main component) and an acylphosphine oxide photoinitiator content of 1 % (product name: Omnirad 819, produced by IGM Resins B.V.) as the photo-radical curable type photo-curable resin liquid. Otherwise, the resin liquid was prepared in the same way as in Example 1. Hereafter, this resin liquid is also referred to as a first liquid.

In Example 5, further, as the photo-radical curable type of photo-curable resin liquid, a resin liquid mix having a bifunctional acrylate monomer content of 99 % (product name: HDDA, produced by Daicel-Allnex Ltd.) and an acylphosphine oxide photoinitiator content of 1 % (product name: Omnirad 819, produced by IGM Resins B.V.) was prepared as a second liquid.

The first liquid and the second liquid were loaded into an MJ-type (inkjet) printer (product name: LaboJet, produced by MicroJet), and 3D shaping was performed to obtain a first-stage shaped object having a disk shape similar to that of Example 3. In Example 5, the first liquid and the second liquid were separately applied, and the portion of the first-stage shaped object where a metal wiring pattern was to be formed was constructed with the first liquid. In the 3D shaping of the first-stage shaped object, each time a two-dimensional drawing was performed with the first liquid and the second liquid, the first-stage shaped object was photo-cured by irradiation with ultraviolet light having a central wavelength of 340 nm using an LED as the light source, and this was repeated to construct the three-dimensional structure of the first-stage shaped object.

The first-stage shaped object was washed with ethanol, and then irradiated with ultraviolet light having a central wavelength of 340 nm (and no light having a wavelength of less than 300 nm) for secondary curing to obtain a second-stage shaped object.

The second-stage shaped object was used in the same manner as in Example 1 to obtain a third-stage shaped object.

Unlike Example 3, an irradiated region was not formed on the third-stage shaped object. As in Example 3, after pretreatment with a pretreatment solution for electroless plating, electroless gold plating with an electroless gold plating solution was performed. As a result, a metal structure similar to the metal structure according to Example 3 was obtained as a metal wiring pattern structure according to Example 5.

### (Example 6)

Example 6 differs from Example 1 in that instead of the pre-made photo-radical curable type of photo-curable resin liquid, a resin liquid mix was used having a bifunctional acrylate monomer content of 89 % (product name: IRR 214-K) and an acylphosphine oxide photoinitiator content of 1 % (product name: Omnirad TPO H, produced by IGM Resins B.V., containing 99 % 2,4,6-trimethylbenzoyl-diphenyl phosphine oxide as the main component) as the photo-radical curable type of photo-curable resin liquid. Further, the sulfonic acid-based acid catalyst (product name: CYCAT^{®} 4040) was replaced with a phosphoric acid-based acid catalyst (product name: NACURE 4167, from Kusumoto Chemicals Ltd., containing 25 % phosphate and 75 % isopropanol and isobutanol mixed solvent as the main components). Otherwise was the same as in Example 1. As with Example 1, electroless gold plating was used to obtain a three-dimensional metal structure having a shape following the surface of the third-stage shaped object.

### (Example 7)

Example 7 differs from Example 1 in that instead of the pre-made photo-radical curable type of photo-curable resin liquid (product name: Clear Resin), 90 % content of another pre-made photo-radical curable type of photo-curing resin liquid (product name: High Temp, produced by Formlabs, having 60 % to 80 % acrylate monomer, 25 % to 45 % urethane acrylate, and 1.5 % acylphosphine oxide photoinitiator as the main components) was used. Otherwise the resin liquid for forming a shaped object was prepared in the same way as in Example 1.

A different SLA-type 3D printer (product name: SPACE ART^{®} (SPACE ART is a registered trademark in Japan, other countries, or both), produced by TKR Corporation) was used for 3D shaping of the first-stage shaped object, but otherwise the first-stage shaped object and the second-stage shaped object were obtained in the same way as in Example 1.

Unlike Example 1, the second-stage shaped object was heated in an oven under an atmosphere with an internal ambient temperature of 280 °C. The heating time in the oven (hold time in the oven) was 3 minutes. Accordingly, the second-stage shaped object was thermoset to obtain a third-stage shaped object.

Further, as with Example 1, electroless gold plating was used to obtain a three-dimensional metal structure having a shape following the surface of the third-stage shaped object.

### (Example 8)

In Example 8, the amounts of the photo-radical curable type of photo-curable resin liquid and the thermosetting resin were changed to check the effect on the metal structure.

Example 8 differs from Example 1 in that, instead of the pre-made photo-radical curable type of photo-curable resin liquid, a resin liquid mix was used having a bifunctional acrylate monomer content of 80 % (product name: IRR 214-K), a bifunctional acrylate monomer content of 19 % (product name: HDDA) and an acylphosphine oxide photoinitiator content of 1 % (product name: Omnirad TPO H, produced by IGM Resins B.V., containing 99 % 2,4,6-trimethylbenzoyl-diphenyl phosphine oxide as the main component) as the photo-radical curable type of photo-curable resin liquid.

As in Example 1, a methylol melamine crosslinking agent (product name: CYMEL^{®} 303 LF) was used as the thermosetting resin.

The acid catalyst (product name: CYCAT^{®} 4040) used was also that used in Example 1.

Resin liquids 1 to 7 for forming shaped objects were prepared from the above photo-radical curable type of photo-curable resin liquid, thermosetting resin, and acid catalyst in the formulations listed in Table 1 below, with different amounts of methylol melamine crosslinking agent (thermosetting resin).

**[Table 1]**

| | | | Resin liquid 1 | Resin liquid 2 | Resin liquid 3 | Resin liquid 4 | Resin liquid 5 | Resin liquid 6 | Resin liquid 7 |
|---|---|---|---|---|---|---|---|---|---|
| Photo-curable resin liquid | HDDA | 19 % | 98 % | 94 % | 89 % | 79 % | 69 % | 49 % | 29 % |
| | IRR-241K | 80 % | | | | | | | |
| | Omnirad TPO H | 1 % | | | | | | | |
| Methylol melamine crosslinking agent | CYMEL 303 LF | | 1 % | 5 % | 10 % | 20 % | 30 % | 50 % | 70 % |
| Acid catalyst | CYCAT 4040 | | 1 % | 1 % | 1 % | 1 % | 1 % | 1 % | 1 % |

For the 3D shaping of the first-stage shaped object, an SLA-type 3D printer (product name: SPACE ART^{®}, produced by TKR Corporation) different from that used in Example 1 was used, and the shape to be formed was a cube-shaped frame (12 external edges). Otherwise, after obtaining the third-stage shaped object using the resin liquids 1 to 7, electroless gold plating was applied to each of the third-stage shaped objects in the same manner as in Example 1.

The third-stage shaped objects using the resin liquids 1 through 7 and the electroless gold plating applied thereto were evaluated for shapeability and good or bad plating.

The evaluation of shapeability for the third-stage shaped objects was done by measuring the length of four external edges. The evaluation was based on three levels. A rating of A was given to an object that was able to be shaped in accordance with design information data (drawing) used by the 3D printer, and was deemed good. A rating of B was given to an object for which a dimensional error of 10 % to 20 % from the design information data occurred and deformation was observed in the third-stage shaped object. A rating of C was given to an object that was more deformed than the object rated B and was therefore deemed defective and unable to be shaped. In other words, a rating of A is when a better shaping result is obtained than in the case of a rating of B.

The plating on the third-stage shaped object was evaluated based on the results of six gold film thickness measurements using an X-ray fluorescence film thickness measuring device (SFT9550, produced by Hitachi High-Tech Corporation). The evaluation was based on three levels. A rating of A was given when a gold film having an average thickness of 150 nm to 250 nm was formed on the surface of the object, and was deemed good. A rating of B was given when a gold film having an average thickness of 50 nm to 150 nm was formed, which indicates an uneven plating film. A rating of C was given when an average thickness of less than 50 nm was detected, which indicates a lack of plating deposition.

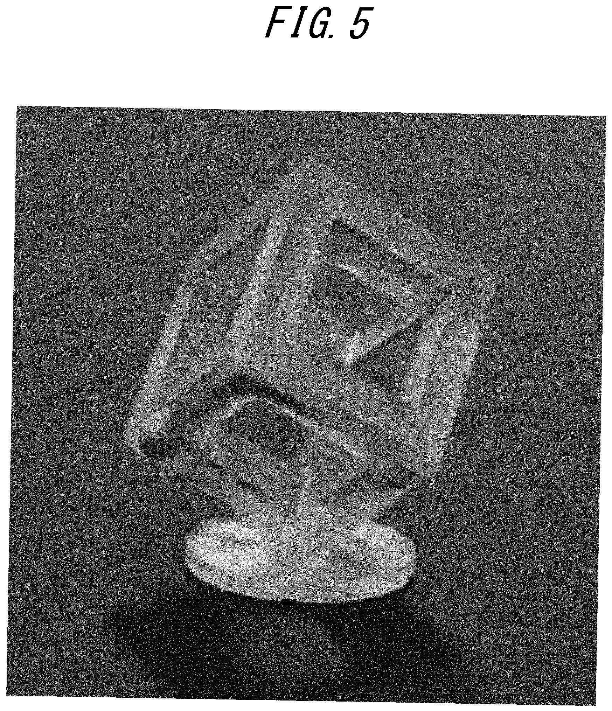

Table 2 below lists the evaluation results for shapeability and plating for the third-stage shaped objects and the electroless gold plating applied thereto using the resin liquids 1 to 7. FIG. 5, FIG. 6, and FIG. 7 illustrate photographs of the third-stage shaped objects made using the resin liquids 1, 3, and 7, that is, shaped objects having thermosetting resin content of 1 %, 10 %, and 70 %.

**[Table 2]**

| | Resin liquid 1 | Resin liquid 2 | Resin liquid 3 | Resin liquid 4 | Resin liquid 5 | Resin liquid 6 | Resin liquid 7 | Evaluation criteria |
|---|---|---|---|---|---|---|---|---|
| Shape | A | A | A | A | A | A | C | A: shaped according to data |
| | | | | | | | | B: deformation in shaped object |
| | | | | | | | | C: shaping not possible |
| Plating | B | A | A | A | A | A | C | A: uniform plating |
| | | | | | | | | B: uneven plating |
| | | | | | | | | C: plating not deposited |

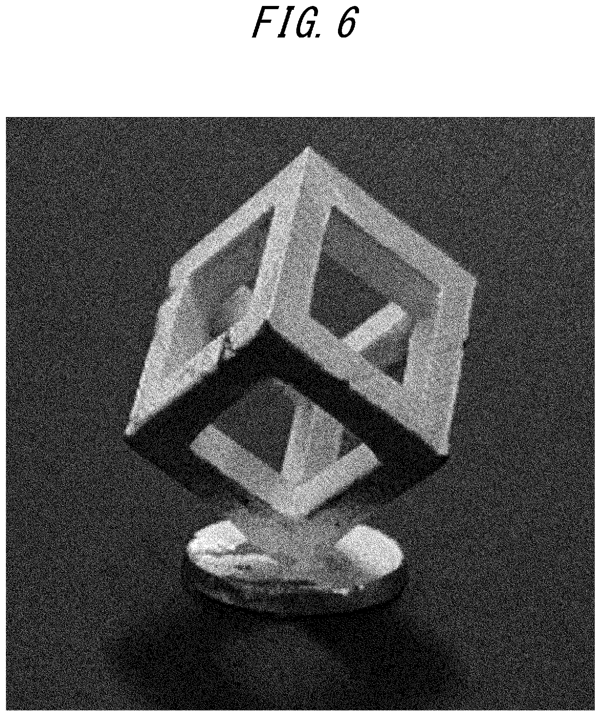

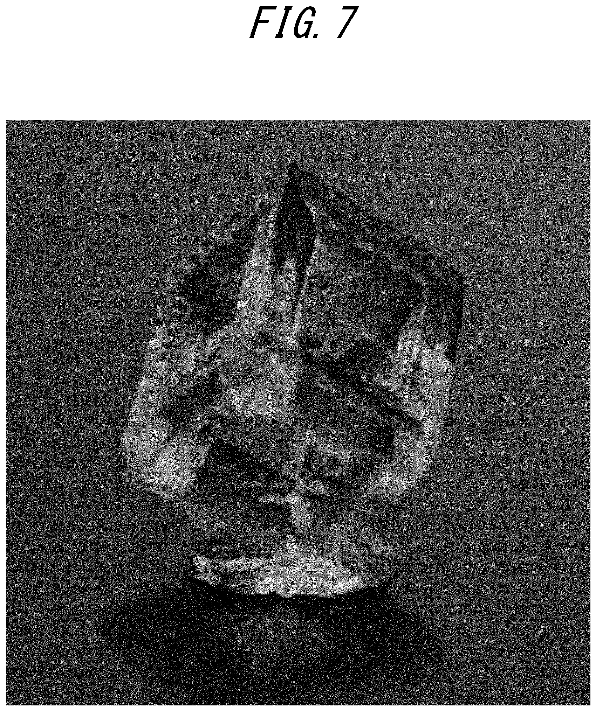

As indicated in Table 2, shapeability and plating ability were good when the resin liquid for forming a shaped object was any of the resin liquids 2 to 6 (thermosetting resin content from 5% to 50%; see, for example, FIG. 6). In contrast, when the thermosetting resin content was 1%, exposure of the substrate was observed and plating was not good (see, for example, FIG. 5). Further, when the thermosetting resin content was 70%, the object was shaped into an irregular shape having a dimensional error of more than 20%, resulting in poor shaping and no plating (see, for example, FIG. 7). Accordingly, the thermosetting resin content in the resin liquid for forming a shaped object is from 3 wt% to 60 wt%, and preferably from 5 wt% to 50 wt%.

As indicated by these examples, the resin liquid and method of forming a shaped object according to the present embodiment can easily construct a shaped object that includes a three-dimensional metal structure. The three-dimensional metal structures that can be constructed by the resin liquid and method of forming a shaped object according to the present embodiment can be used, for example, as electrical wiring patterns.

As described above, a resin liquid and a method of forming a shaped object suitable for producing a shaped object including a three-dimensional metal structure can be provided.

Each configuration described according to the above embodiments (including other embodiments, the same applies hereinafter) may be applied in combination with a configuration described according to another embodiment, as long as no contradiction arises. The embodiments described herein are examples, the present disclosure is not limited to the described examples, and appropriate modifications may be made within a scope that does not depart from the spirit of the present disclosure.

### INDUSTRIAL APPLICABILITY

The present disclosure is applicable to resin liquids and methods of forming shaped objects.

### REFERENCE SIGNS LIST

11: structure
31, 32, 33, 34, 35: structure
40: helical tunnel space
41: structure

## Claims

1. A resin liquid comprising: a photo-radical curable resin; a thermosetting resin; and an acid catalyst, wherein
the thermosetting resin comprises a melamine crosslinking agent or a benzoguanamine crosslinking agent, and
the thermosetting resin content is 3 wt% to 60 wt%.

2. The resin liquid according to claim 1, wherein the photo-radical curable resin comprises at least one selected from the group consisting of urethane acrylate, epoxy acrylate, acrylic acrylate, polyester acrylate, and acrylate monomer.

3. The resin liquid according to claim 1 or 2, wherein the melamine crosslinking agent comprises methylol melamine or a methylol melamine derivative.

4. The resin liquid according to any one of claims 1 to 3, wherein the benzoguanamine crosslinking agent comprises methylol benzoguanamine or a methylol benzoguanamine derivative.

5. The resin liquid according to any one of claims 1 to 4, wherein, in terms of solid content mass ratio, 40 % to 97 % is the photo-radical curable resin.

6. The resin liquid according to any one of claims 1 to 5, wherein the acid catalyst comprises a sulfonic acid-based acid catalyst or a phosphoric acid-based acid catalyst.

7. A method of forming a shaped object, the method comprising:
a shaping process of shaping using a resin liquid, wherein the resin liquid comprises a photo-radical curable resin, a thermosetting resin, and an acid catalyst, the thermosetting resin comprises a melamine crosslinking agent or a benzoguanamine crosslinking agent, and the thermosetting resin content is 3 wt% to 60 wt%, to obtain a first-stage shaped object;
a finishing photo-curing process of irradiating the first-stage shaped object with light having a wavelength of 300 nm or more to photo-cure the first-stage shaped object to obtain a second-stage shaped object; and
a thermosetting process of heating the second-stage shaped object to a temperature from 60 °C to 280 °C to thermoset the second-stage shaped object to obtain a third-stage shaped object.

8. The method of forming a shaped object according to claim 7, further comprising a patterning process of irradiating a portion of the surface of the third-stage shaped object with light having a wavelength of less than 300 nm to form an irradiated region irradiated with light having a wavelength of less than 300 nm and a non-irradiated region that is not irradiated with light having a wavelength of less than 300 nm.

9. The method of forming a shaped object according to claim 7 or 8, further comprising a catalyst loading process of bringing a pretreatment solution for electroless plating comprising metal nanoparticles and water into contact with the surface of the third-stage shaped object to load the metal nanoparticles onto the surface of the third-stage shaped object to form a catalyst loaded region.

10. The method of forming a shaped object according to claim 9, further comprising a plating process of applying electroless plating to the catalyst loaded region.
